# EUROPÄISCHE PATENTSCHRIFT

(11) **EP 0 678 911 B1**
(45) Veröffentlichungstag und Bekanntmachung des Hinweises auf die Patenterteilung: **30.01.2002**
(21) Anmeldenummer: 95105933.6
(22) Anmeldetag: 20.04.1995
(51) Int. Cl.: H01L 21/66, G01R 31/311, G01N 21/88

(54) **Verfahren und Vorrichtung zur Kontrolle von Halbleiterscheiben**
System and method for inspecting semiconducter wafers
Système et appareil pour l'inspection des plaquettes semi-conductrices

(30) Priorität: 20.04.1994 DE 4413831
(43) Veröffentlichungstag der Anmeldung: 25.10.1995
(73) Patentinhaber: Infineon Technologies AG, 81669 München (DE)
(72) Erfinder: Biedermann, Ernst, D-93053 Regensburg (DE); Grieshop, Matthias, D-93073 Neutraubling (DE); Ben el Mekki, Manfred, D-82256 Fürstenfeldbruck (DE); Weisheit, Kenneth, D-86154 Augsburg (DE); Griebsch, Thomas, D-81543 München (DE); Ross, Gerhard, D-80689 München (DE)
(74) Vertreter: Zedlitz, Peter, Dipl.-Inf.

(56) Entgegenhaltungen:
- EP-A- 0 146 005
- EP-A- 0 319 797
- EP-A- 0 560 096
- US-A- 4 958 373
- US-A- 5 091 963
- US-A- 5 394 246
- MICROELECTRONICS JOURNAL, Bd. 24, Nr. 6, Oktober 1993 LUTON GB, Seiten 625-633, H. TSUKAHARA ET AL. 'Automated Visual Inspection System for Bonded IC Wires'

## Beschreibung

Die Erfindung betrifft ein Verfahren zur Kontrolle von Halbleiterscheiben, insbesondere einer Charge von Halbleiterscheiben Eine Charge von Halbleiterscheiben sind bekanntlich mehrere Halbleiterscheiben, die Bestandteil eines einzigen Fertigungsloses sind. Die zu kontrollierenden Halbleiterscheiben weisen bereits mindestens eine erste Schicht mit Strukturen auf sowie, als oberste Schicht, eine Lackschicht. Die Halbleiterscheiben dienen der Herstellung integrierter Halbleiterspeicher. Bei dem Verfahren sind die oberste Schicht, d. h. die Lackschicht, sowie darunterliegende Halbleiterstrukturen auf einwandfreie Beschaffenheit zu kontrollieren. Dabei sollen fehlerhafte Halbleiterscheiben erkannt werden, so daß sie vom weiteren Fertigungsablauf entweder ganz ausgeschlossen werden können oder aber, daß sie vor dem weiteren Fertigungsablauf entsprechend nachbearbeitet werden können und dann, Fehlerfreiheit vorausgesetzt, wieder in den normalen Fertigungsablauf eingeschleust werden können.

Solche Kontrollen von Halbleiterscheiben auf einwandfreie Beschaffenheit (z. B. Kontrolle auf Partikelfreiheit, d. h. frei von Verschmutzungen und Ablagerungen, Kontrolle auf gleichmäßig dicke Lackschicht oder auf Fehlstellen bei der Lackschicht) ist bekanntlich eminent wichtig für das Erzielen guter Ausbeuten im Fertigungsprozeß.

Diese Kontrollen werden zuweilen manuell durchgeführt mit Hilfe von Mikroskopen oder ohne Mikroskop mittels schräg einfallendem Licht. Dies ist zum einen für das Personal sehr anstrengend, insbesondere für die Augen und den Rücken (Körperhaltung, stundenlanges Sitzen). Zum anderen ist es aber auch mit großen Unsicherheiten behaftet, weil beim Personal mit der Zeit die Konzentrationsfähigkeit nachläßt beim Erkennen von Fehlern und beim Sortieren nach guten und schlechten Scheiben.

In der US-A-5,091,963 wird ein Verfahren zur Kontrolle der Herstellung integrierter Halbleiterscheiben für unterschiedliche Anwendungsfälle beschrieben. Mittels einer Vorrichtung und Auswerteeinrichtung werden zu untersuchende Bereiche der Halbleiterscheibe ermittelt und kontrolliert. Die Oberflächenstruktur wird auf einzelne Bereiche von Unregelmäßigkeiten hin untersucht, die sich von einer weitgehend einheitlichen Färbung und/oder Schattierung des Hintergrunds abheben. Diese Bereiche deuten auf mögliche Inhomogenitäten des Materials hin und sind ein Kriterium dafür, ob die betrachtete Halbleiterscheibe die für bestimmte Anwendungsfälle geltenden Standards erfüllt.

In der US-A-4,958,373 wird ein Verfahren zur Kontrolle der Oberfläche eines Wafers beschrieben, in dem ein Bild der Oberfläche gespeichert wird und einzelne, als mögliche Defekte erkannte Stellen lokal ausgewertet werden. Diese werden erkannt, indem vorher ein Referenzbild erstellt wird und dadurch jeweilige Bezugswerte für spätere Meßgrößen (Reflexionsgrade) ermittelt werden. Wird eine solche Referenzgröße an einer Stelle überschritten, ist ein möglicher Defekt lokalisiert. Anschließend werden die Größen eines möglichen Defektes gemessen. Nachfolgend werden diese Werte anhand weiterer vorher festgelegter Referenzwerte daraufhin überprüft, ob tatsächlich ein Fehler an dieser Stelle vorliegt oder ob es sich um Schmutz o.ä. handelt.

Aufgabe der vorliegenden Erfindung ist es, den Vorgang des Kontrollierens möglichst fehlerfrei gestalten zu können und die gesundheitlichen Belastungen des Personals reduzieren zu können.

Diese Aufgabe wird beim erfindungsgemäßen Verfahren gelöst durch die Merkmale des Patentanspruches 1.

Vorteilhafte Aus- und Weiterbildungen sind in Unteransprüchen gekennzeichnet.

Die Erfindung wird nachstehend anhand einer Zeichnung näher erläutert. Dabei zeigen:
- die Figuren 1 bis 3: vorteilhafte Ausführungsformen der das Verfahren ermöglichenden Vorrichtungen,
- die Figuren 4 bis 8: Einzelheiten des erfindungsgemäßen Verfahrens.

Bevor das erfindungsgemäße Verfahren näher beschrieben wird, wird zunächst eine erste Ausführungsform der für das Verfahren geeigneten Vorrichtung kurz erläutert:

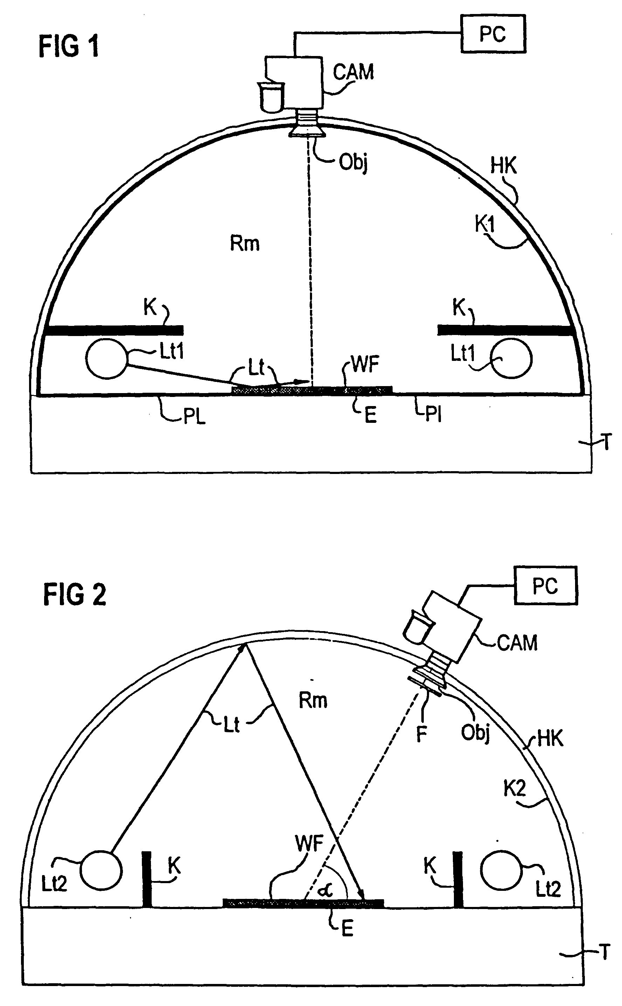

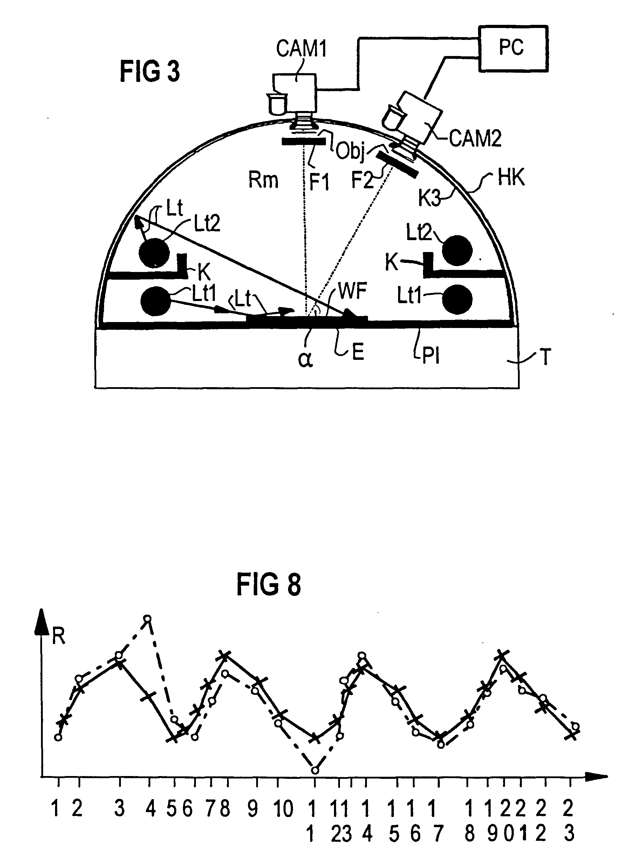

Figur 1 zeigt die Vorrichtung, die beispielsweise auf einem Tisch T (gilt auch für die weiteren beiden Vorrichtungen nach den Figuren 2 und 3) oder einer sonstigen geeigneten Unterlage mit festem Stand angeordnet sein kann. Die Vorrichtung weist eine Einrichtung E auf zur Aufnahme der zu kontrollierenden Halbleiterscheibe WF sowie eine Bodenplatte Pl. Die Bodenplatte Pl ist jedoch nicht zwingend notwendig. Die Einrichtung E kann Bestandteil der Bodenplatte Pl sein. Sie kann aber auch, gemäß weiteren Ausgestaltungen der Vorrichtung, auf der Bodenplatte Pl angeordnet oder in diese eingelassen sein. Die Vorrichtung weist weiterhin eine halbkugelförmige Abdeckeinrichtung HK auf, welche mit der Bodenplatte Pl einen weitgehend geschlossenen Innenraum Rm bildet und die im Innenraum Rm eine auftreffendes Licht Lt weitgehend absorbierende Oberfläche K1 hat, die gegebenenfalls schwarz ist.

Innerhalb dieses Innenraums Rm ist eine vorzugsweise, jedoch nicht unbedingt notwendigerweise ringförmige Beleuchtungseinrichtung Lt1 angeordnet, die einer direkten Beleuchtung der zu kontrollierenden Halbleiterscheibe WF dient. D. h., die Halbleiterscheibe WF wird unter einem flachen Winkel zur Oberfläche der Halbleiterscheibe WF beleuchtet, wie anhand eines Lichtstrahls Lt aus Figur 1 ersichtlich. Die ringförmige Ausgestaltung ermöglicht eine gleichmäßige Beleuchtung der Halbleiterscheibe WF. Die halbkugelförmige Abdeckeinrichtung HK weist innerhalb des abgeschlossenen Raumes Rm eine Oberfläche K1 auf, welche auftreffendes Licht Lt absorbiert.

Oberhalb der Beleuchtungseinrichtung Lt1 ist eine weitere Abdeckeinrichtung K angeordnet, welche auftreffendes Licht Lt nicht durchläßt und nach Möglichkeit absorbiert. Sie ist so ausgebildet, daß die Halbleiterscheibe WF direkt beleuchtbar ist mittels der Beleuchtungseinrichtung Lt1, während die halbkugelförmige Abdeckung HK größtenteils gegenüber dem direkten Licht der Beleuchtungseinrichtung Lt1 abgedeckt ist. Infolge dieser Anforderungen ist es insbesondere bei ringförmiger Auslegung der Beleuchtungseinrichtung Lt1 günstig, auch die weitere Abdeckeinrichtung K ringförmig auszulegen. Senkrecht oberhalb des Mittelpunktes der Einrichtung E zur Aufnahme der zu kontrollierenden Scheibe WF ist an der halbkugelförmigen Abdeckeinrichtung HK eine Kamera CAM so angeordnet, daß ihr Objektiv Obj in den abgeschlossenen Raum Rm blickt, insbesondere auf die Stelle, an der sich im Betrieb die zu kontrollierende Halbleiterscheibe WF befindet. Die Kamera CAM kann dabei so angeordnet sein, daß ihr Objektiv Obj in den abgeschlossenen Innenraum Rm hineinragt, wie in Figur 1 dargestellt, oder aber auch so, daß der Rand ihres Objektives Obj in etwa bündig mit der halbkugelförmigen Abdeckung HK abschließt.

Die Kamera CAM ist mit einer Auswerteeinrichtung PC verbunden, die der Steuerung der Kamera dient sowie zum Empfang, zur Zwischenspeicherung, zur Verarbeitung und zur Ausgabe von von der Kamera CAM übermittelten Daten. Diese Daten können analog (in Form von "Bildern") oder digital übermittelt werden, sofern die Kamera CAM bereits für Digitalübermittlung ausgerüstet ist (z. B., wenn sie A/D-Wandler aufweist). Die Auswerteeinrichtung PC ist dabei typischerweise eine Rechnereinrichtung wie ein Personal Computer oder eine Datenverarbeitungsanlage. Es ist aber auch vorstellbar, daß sie ausschließlich aus das noch zu beschreibende Verfahren ausführender Hardware gebildet ist.

Folgende Ausgestaltungen der Vorrichtung sind vorteilhaft:
Die das Licht Lt absorbierende Oberfläche K1 der halbkugelförmigen Abdeckung HK ist schwarz.

Das von der Beleuchtungseinrichtung Lt1 ausgesandte Licht Lt ist weiß.

Die weitere Abdeckeinrichtung K hat eine schwarze Oberfläche.

Die Oberfläche der Bodenplatte Pl ist auf ihrer der halbkugelförmigen Abdeckeinrichtung HK zugewandten Seite schwarz.

Soweit sich im Innenaum Rm weitere Teile der Kamera CAM befinden, so sind die diese so angeordnet, daß sie, von der zu kontrollierenden Halbleiterscheibe WF her betrachtet, durch das Objektiv Obj verdeckt sind.

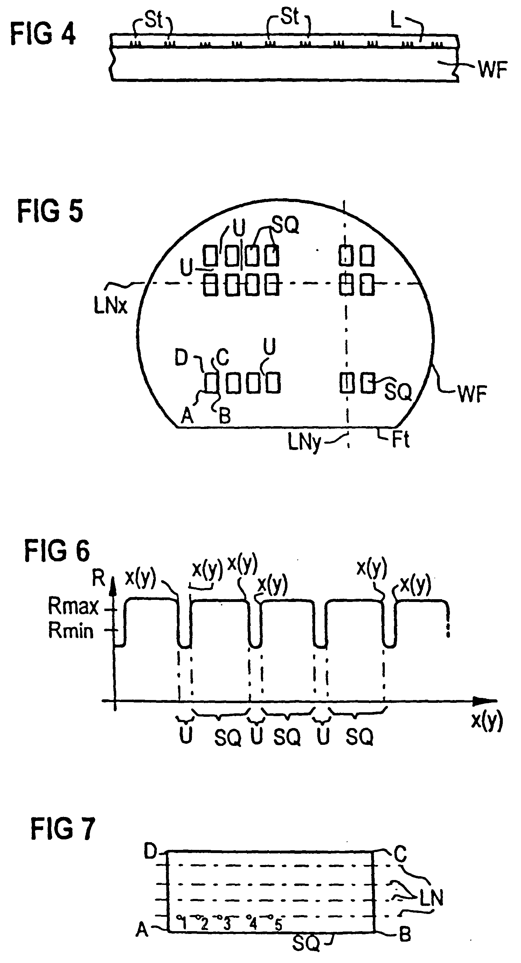

Mittels dieser Vorrichtung und ggf. seiner vorteilhaften Weiterbildungen ist nun das nachstehend in Verbindung mit den Figuren 4 bis 8 beschriebene Verfahren durchführbar. Es ist geeignet zur Kontrolle sowohl einzelner Halbleiterscheiben WF wie auch zur Kontrolle mehrerer bis aller Halbleiterscheiben WF einer Charge von Halbleiterscheiben WF (d. h. also, von Halbleiterscheiben WF, die Bestandteil eines gemeinsamen Fertigungsloses sind), wobei im Falle der Kontrolle von Halbleiterscheiben WF einer Charge bestimmte Verfahrensschritte nur bei der ersten Halbleiterscheibe WF dieser Charge unbedingt notwendig sind. Die Ergebnisse dieser bestimmten Verfahrensschritte sind, bei geeigneter Zwischenspeicherung mittels der Auswerteeinrichtung PC, für die Kontrolle der weiteren Halbleiterscheiben WF der betreffenden Charge weiter verwendbar. Diese Verfahrensschritte, welche nur bei der ersten Halbleiterscheibe WF einer Charge zwingend notwendig sind, sind nachstehend noch angegeben.

Da Halbleiterscheiben WF häufig ein sogenanntes Flat Ft (siehe Figur 5) aufweisen (d. h., ein Bereich der an sich runden Halbleiterscheibe WF ist abgeflacht), wird beim Ausführungsbeispiel des nachstehenden Verfahrens davon ausgegangen, daß die zu kontrollierenden Halbleiterscheiben WF ein solches Flat Ft aufweisen. Die Halbleiterscheiben WF könnten jedoch stattdessen eine Einkerbung aufweisen, was jedoch im Prinzip keinen Einfluß auf das Verfahren hat. Selbst Halbleiterscheiben WF ohne solche Orientierungshilfen könnten mittels des Verfahrens kontrolliert werden, wenn beispielsweise Bildverarbeitungsprogramme benutzt werden, welche die Orientierung der nachstehend noch beschriebenen rechteckigen Flächen SQ ermitteln können. Weiterhin ist zugrunde gelegt, daß die im Herstellungsprozeß auf den Halbleiterscheiben WF zu bildenden Halbleiterchips rechteckig, ggf. quadratisch sind und daß sie parallel zum Flat Ft ausgerichtet sind. Zwar ist das erfindungsgemäße Verfahren auch auf solche Halbleiterscheiben WF anwendbar, die diese Voraussetzungen nicht erfüllen, jedoch sind dann noch zusätzlich Positionierungsschritte notwendet zum Ausrichten der Halbleiterscheibe WF in eine allen Scheiben gemeinsame Position und/oder Umrechnen von Positionen der einzelnen, auf der Halbleiterscheibe WF zu fertigenden Chips, was jedoch keinerlei erfinderische Tätigkeit bedingt im Vergleich zur erfindungsgemäßen Lehre.

Weiterhin ist noch angenommen, daß die mittels der zu kontrollierenden Halbleiterscheibe WF zu fertigenden Halbleiterchips integrierte Halbleiterspeicher sind, die bekanntlich unabhängig von ihrer Speicherart {z. B. flüchtige Speicher wie DRAM's, SRAM's, nicht-flüchtige Speicher (NV-Memories) wie ROM's, PROM's, EEPROM's}, große Bereiche SQ (siehe Figur 5) regelmäßiger Strukturen aufweisen (die sogenannten Speicherzellenblöcke oder Speicherzellenfelder) sowie Bereiche unregelmäßiger Strukturen, welche z. B. die sogenannten peripheren Schaltungen, wie z. B. Decoder und Verstärker und die Anschlußflächen (pads) enthalten. Die Bereiche regelmäßiger Strukturen SQ umfassen in der Regel ca. 80 bis 95% des gesamten Speicherchips. Außerdem sind auf einer solchen Halbleiterscheibe WF noch Bereiche zwischen den einzelnen Chips angeordnet, welche einem Zerteilen der (fertigen) Halbleiterscheibe WF zur Montage der einzelnen Chips in ein Gehäuse, in eine Chipkarte oder ähnlichem dienen (allgemein mit Ritz-Rahmen bezeichnet). Bei dem erfindungsgemäßen Verfahren werden lediglich die Bereiche regelmäßiger Strukturen SQ kontrolliert, was in Anbetracht ihres großen Anteils an der Gesamtfläche der Halbleiterscheibe WF völlig ausreichend ist.

Darüber hinaus ist noch Voraussetzung für das erfindungsgemäße Verfahren, daß die Halbleiterscheibe WF (dargestellt in Figur 4) wenigstens eine Schicht aufweist, die bereits Strukturen St der zu fertigenden Halbleiterchips enthält, sowie als oberste Schicht eine Lackschicht L (für weitere Strukturierungsschritte), die zu kontrollieren sind (dargestellt in Figur 4).

Ein wesentliches Merkmal des erfindungsgemäßen Verfahrens ist, daß die Kontrolle automatisch abläuft, d. h. ohne Zwischenschaltung menschlicher Tätigkeiten. Dies schont zum einen die Gesundheit des Personals (siehe eingangs geschilderte Nachteile zum Stand der Technik). Zum anderen fördert es aber auch die Genauigkeit der Kontrolle aus folgenden Gründen:
- Bei gleicher oder gar kürzerer Meßzeit (pro Scheibe) können mehr Meßpunkte kontrolliert werden, d. h. die Kontrolle ist genauer,
- Menschliche Fehlentscheidungen (Verwechseln der Erkennung von Gut/Ausfall und der Sortierung nach Gut/Ausfall) sind ausgeschlossen,
- Bei kürzerer Meßzeit pro Scheibe erhöht sich der Durchsatz, d. h. die Produktivität je Mitarbeiter.

Darüber hinaus eröffnet das erfindungsgemäße Verfahren auch die Möglichkeit, daß ein Mitarbeiter mehrere Vorrichtungen, welche das Verfahren durchführen, bedient (z. B. Auflegen und Abnehmen der Scheiben, soweit nicht automatisiert; Start des Verfahrens, soweit nicht automatisiert) und/oder kontrolliert, so daß die Produktivität nochmals erhöht werden kann (höhere Produktivität bedeutet bekanntlich niedrigere Herstellungskosten, was heutzutage eminent wichtig ist für die Hersteller integrierter Schaltungen, insbesondere für die Hersteller von integrierten Halbleiterspeichern).

Das erfindungsgemäße Verfahren ist so ausgestaltet, daß wenigstens für die erste Halbleiterscheibe WF einer Charge (oder selbstverständlich auch möglich bei anderen bis allen restlichen Halbleiterscheiben WF dieser Charge) folgende Vorgänge ablaufen bzw. durchgeführt werden:
Die Halbleiterscheibe WF wird direkt beleuchtet durch die Beleuchtungseinrichtung Lt1, vorzugsweise mit weißem Licht. Die auf die Halbleiterscheibe WF aufgebrachte Lackschicht L reflektiert das Licht Lt.

Mittels der senkrecht über der Halbleiterscheibe WF angeordneten Kamera CAM, welche aufgrund ihrer Anordnung auf die Halbleiterscheibe "blickt", wird nun der Reflexionsgrad R des reflektierten Lichtes Lt nach folgendem Vorgehen ermittelt (unter Reflexionsgrad R wird hierbei das Maß der Helligkeit verstanden, die von der Halbleiterscheibe WF her auf das Objektiv der Kamera CAM trifft bzw. wirkt):
Zunächst wird mittels der Auswerteeinrichtung PC eine erste Linie LNx, die als Meßlinie dient und die in gegebenem Abstand parallel zum Flat Ft verläuft, auf der Oberfläche des Lackes L der Halbleiterscheibe WF simuliert, d. h. "gedacht". Die Helligkeit der Halbleiterscheibe WF, d. h., der Wert des Reflexionsgrades R, wird entlang dieser gedachten Linie LNx an ausgewählten Punkten Px ("Pixel", nicht dargestellt aus Gründen der Übersichtlichkeit) durch Kamera CAM und Auswerteeinrichtung PC ermittelt und zusammen mit dem Lagewert x dieser Punkte Px in der Auswerteeinrichtung PC zwischengespeichert.

Ergeben sich längs dieser gedachten Linie LNx mehrheitlich Werte des ermittelten und gemessenen Reflexionsgrades R, welche unterhalb eines vorgegebenen Mindestwertes Rmin liegen, so werden die ermittelten und zwischengespeicherten Daten bezüglich dieser Linie LNx als unbrauchbar verworfen. Es wird nämlich angenommen, daß die Linie LNx überwiegend nicht durch die großen Flächen SQ der regelmäßigen Strukturen verläuft, sondern durch die Bereiche unregelmäßiger Strukturen oder durch einen Ritz-Rahmen. Diese Bereiche und der Ritz-Rahmen ("U" genannt; vergleiche Figur 5) sollen jedoch vereinbarungsgemäß nicht kontrolliert werden. Statt der bislang vermessenen gedachten Linie LNx wird nun, in gegebenem Abstand zu dieser gedachten Linie LNx, eine weitere "gedachte" Linie LNx1 ausgewählt und verwendet (in Figur 5 aus Gründen der Übersichtlichkeit nicht dargestellt), bezüglich deren der Reflexionsgrad R genauso ermittelt und zwischengespeichert wird samt den zugehörigen Lagewerten x wie bezüglich der ursprünglich verwendeten gedachten Linie LNx.

Sollten die Werte des Reflexionsgrades R dieser weiteren gedachten Linie LNx1 auch mehrheitlich Werte aufweisen unterhalb des Mindestwertes Rmin, so wird der gesamte Vorgang "Verwerfen der Daten dieser Linie LNx1, Annahme einer weiteren gedachten Linie LNx2, Ermitteln und Auswerten der Werte ihres Reflexionsgrades R und der zugehörigen Lagewerte x, sowie Zwischenspeichern" nochmals durchgeführt entsprechend dem oben beschriebenen.

Dies erfolgt insgesamt so oft, bis eine gedachte Linie LNx, LNx1, LNx2... gefunden wurde, deren Werte des Reflexionsgrades R mehrheitlich dem Kriterium des Mindestwertes Rmin genügen. Falls eine solche gedachte Linie LNx, LNx1,... nicht ermittelt werden kann (ggf. beschränkt auf eine Höchstzahl an Versuchen, eine geeignete Linie LNx zu finden), die dieses Kriterium erfüllt, so wird die Kontrolle dieser Halbleiterscheibe WF abgebrochen, weil angenommen wird, daß entweder ein Fehler größeren Ausmaßes vorliegt oder aber die Halbleiterscheibe WF vielleicht noch gar keine Strukturen St aufweist unterhalb der Lackschicht L.

In dem Fall, in dem die Suche nach einer gedachten Linie LNx,..., die parallel zum Flat Ft liegt, zu Werten des Reflexionsgrades R geführt haben, die mehrheitlich dem Kriterium des minimalen Reflexionsgrades Rmin genügen, wird nun, ganz entsprechend dem bisherigen, irgendwo über die zu kontrollierende Halbleiterscheibe WF senkrecht zur gefundenen gedachten Linie (künftig sei angenommen, daß dies die erste gedachte Linie LNx war) eine neue gedachte Linie LNy simuliert. Entlang deren werden an Meßpunkten Py wiederum die Werte des Reflexionsgrades R des reflektierten Lichtes Lt (samt deren zughörigen Lagewerten y) mittels der Kamera CAM und der Auswerteeinrichtung PC gemessen und zwischengespeichert. Auch diese Werte müssen mehrheitlich dem Kriterium des minimalen Reflexionsgrades Rmin genügen (wobei aber vorstellbar ist, daß dieser ggf. einen anderen Wert aufweisen kann bezüglich der gedachten Linie LNx parallel zum Flat Ft). Falls sie nicht genügen, werden bezüglich der neuen gedachten Linie LNy die bezüglich der gedachten Linie LNx bereits beschriebenen Schritte zum Finden einer gedachten Linie LNx1, LNx2,... analog ausgeführt mit weiteren neuen gedachten Linien LNy1, LNy2 usw. (jeweils in einem gegebenen Abstand zur vorher vermessenen neuen gedachten Linie LNy, LNy1 etc.) so lange, bis entweder erkannt ist (ggf. nach einer vorgegebenen maximalen Zahl von Versuchen), daß keine neue gedachte Linie LNy,... gefunden werden kann, die dem Kriterium des minimalen Reflexionsgrades Rmin genügt (dann erfolgt Abbruch der Kontrolle der betroffenen Halbleiterscheibe WF) oder aber bis eine solche Linie gefunden ist (angenommenermaßen sei dies für die weitere Beschreibung die ursprüngliche Linie LNy).

In dem Fall, in dem verwendbare gedachte Linien LNx und LNy gefunden werden konnten, sind also die Lagewerte x (für die gedachte Linie LNx) und y (für die gedachte Linie LNy) der jeweiligen Meßpunkte dieser Linien LNx und LNy bereits zwischengespeichert. Die Lagewerte sind bezogen auf die Lage des Flats Ft. Die Meßpunkte Px und Py sollten nach Möglichkeit in so engem Abstand zueinander gelegt worden sein, daß damit möglichst genau (d. h., über deren zugehörigen Werte des Reflexionsgrades R) die Grenzen zwischen den jeweiligen Flächen SQ regelmäßiger Strukturen zu den Bereichen U (unregelmäßige Strukturen und Ritz-Rahmen) erfaßt sind.

Figur 6 zeigt beispielhaft den Verlauf der gemessenen Werte des Reflexionsgrades R entlang der gedachten Linie LNx. Gleiches gilt entsprechend der gedachten Linie LNy, was durch die in Klammern besetzte Bezeichnung "y" auf der Abszisse angedeutet ist. Dabei steht "SQ" für die (angenommenermaßen rechteckigen) großen Flächen SQ regelmäßiger Strukturen während "U" für die (kleineren) Bereiche unregelmäßiger Strukturen sowie der jeweiligen Ritz-Rahmen steht. Die weiteren verwendeten Bezeichnungen "X" und "Y" (in Klammern stehend) werden nachstehend noch erläutert. Dem Bild zugrunde liegt die Tatsache, daß die großen Flächen SQ regelmäßiger Strukturen im Normalfall hohe Werte des Reflexionsgrades R aufweisen, während die Bereiche U einen meist deutlich niedrigeren Wert des Reflexionsgrades R aufweisen.

Für die weiteren Schritte des Verfahrens, d. h. für eine Halbleiterscheibe WF, für die gedachte Linien LNx, LNy gefunden worden waren, die dem Kriterium des Minimalwertes Rmin genügten, sind nun diejenigen Punkte, d. h. die Koordinaten X, Y (siehe Figur 6) interessant, die am Rand der großen Flächen SQ regelmäßiger Strukturen zu den restlichen Bereichen U unregelmäßiger Strukturen und der Ritz-Rahmen liegen (d. h. die Eckpunkte A, B, C, D der großen Flächen SQ, wie in den Figuren 5 und 7 gezeigt), da die Bereiche U vereinbarungsgemäß von der Kontrolle ausgeschlossen sein sollen. Zu diesem Zweck werden aus den Lagepunkten x der einen gedachten Linie LNx (bzw. der als Ersatz dafür vewendeten weiteren gedachten Linie LNx1 bzw. LNx2 bzw. ...) und den Lagepunkten y der anderen gedachten Linie LNy (bzw. der als Ersatz dafür verwendeten weiteren gedachten Linie LNy1 bzw. LNy2 bzw. ...), deren zugehöriger Werte des Reflexionsgrades R sowie der Information, daß die Flächen SQ (d. h. die Speicherzellenfelder) rechteckig sind, diese Koordinaten X, Y mittels der Auswerteeinrichtung PC ermittelt.

Die Ermittlung erfolgt in mathematisch leicht durchführbarer Art aus der Information, daß die großen Flächen SQ Rechtecke bilden, die sich in x- und y-Richtung (d. h. parallel und senkrecht zum Flat Ft und somit parallel bzw. senkrecht zu den gedachten Linien LNx, LNy) regelmäßig wiederholen und aus dem Beurteilungskriterium, daß nur solche Lagepunkte x bzw. y der beiden gedachten Linien LNx, LNy berücksichtigt werden, deren zugehöriger Wert des Reflexionsgrades R einen vorgegebenen Maximalwert Rmax zwar überschreiten, die jedoch gleichzeitig Nachbarpunkte von solchen Lagewerten x bzw. y sind, die diesen Maximalwert Rmax unterschreiten. Alle Lagepunkte x bzw. y, deren zugehöriger Wert des Reflexionsgrades R unterhalb dieses Maximalwertes Rmax liegen, werden vom weiteren Verfahren ausgeblendet als Bereiche U, die nicht zu kontrollieren sind.

Damit sind bezüglich der zu kontrollierenden Halbleiterscheibe WF sämtliche rechteckigen Flächen SQ (die ggf. auch quadratisch sein könnten als Spezialfall eines Rechteckes) definiert, innerhalb deren die Kontrolle erfolgen soll. Die Bereiche U seien vereinbarungsgemäß von der Kontrolle ausgeschlossen. Weiterhin sind von der Kontrolle auch unvollständige Flächen SQ, die den sogenannten unvollständigen Randchips einer Halbleiterscheibe WF entsprechen, ausschließbar.

Da die geometrische Anordnung der Flächen SQ und der Bereiche U bei allen Halbleiterscheiben WF einer Charge bezüglich deren Flats Ft gleich sind (aufgrund des gemeinsamen Herstellungsprozesses), können (nicht: müssen) die Koordinaten X, Y der Flächen SQ, die gemäß den vorstehenden Verfahrensschritten ermittelt und zwischengespeichert wurden, auch für die weiteren Halbleiterscheiben WF derselben Charge bei entsprechender Ausrichtung dieser Scheiben auf der Einrichtung E verwendet werden, so daß die vorstehenden Verfahrensschritte bei der Kontrolle der weiteren Halbleiterscheiben WF derselben Charge entfallen können. Dies erspart Rechenzeit.

Die weiteren Verfahrensschritte, die nachstehend bezüglich einer Fläche SQ beschrieben werden, werden sukzessive auf jede einzelne rechteckige Fläche SQ der Halbleiterscheibe WF angewandt. Sie basieren ebenfalls auf dem Prinzip gedachter Linien, die jedoch im Unterschied zu den vorstehend genannten gedachten Linien LNx, LNy nunmehr als Meßlinien LN bezeichnet werden.

Bei jeder der zu kontrollierenden rechteckigen Flächen SQ (siehe Figur 7) wird wenigstens eine Meßlinie LN "gedanklich" parallel zu einer Kante (in Figur 7 beispielhaft dargestellt anhand von vier Meßlinien LN: parallel zur Kante AB bzw. CD) "gelegt". Dies geschieht vorzugsweise parallel zur längeren Kante der Fläche SQ; es kann aber auch parallel zur kürzeren Kante erfolgen.

Entlang jeder dieser Meßlinien LN wird mittels der Kamera CAM und der Auswerteeinrichtung PC an vorgegebenen Meßpunkten 1, 2, 3,... der jeweilige Wert des Reflexionsgrades R ermittelt und zwischengespeichert. Je mehr Meßlinien LN je Fläche SQ verwendet werden und je mehr solche Punkte 1, 2, 3,... vorgegeben sind, desto genauer ist die Kontrolle.

Für den Reflexionsgrad R entlang zweier ausgewählter Meßlinien LN ergeben sich beispielsweise die in Figur 8 dargestellten beiden Verläufe (die nicht notwendigerweise eine Art Sinuskurve sein müssen). Auf der Abszisse sind die Meßpunkte 1 bis 23 aufgetragen. Auf der Ordinate ist der jeweilige Wert des Reflexionsgrades R ablesbar.

Die mit "x" eingetragenen Werte des Reflexionsgrades R sind Werte entlang einer ersten Meßlinie LN. Wie die nachstehend noch aufgeführten möglichen Kriterien zur Erkennung, ob ein Fehler vorliegt oder nicht, zeigen, ist entlang dieser Meßlinie kein Fehler erkennbar. Es liegen zwar verschiedene Werte des Reflexionsgrades R vor (verursacht durch die verschiedenen Strukturen innerhalb der Fläche SQ, unterhalb der Lackschicht L). Diese sind jedoch, wie anhand der nachstehend genannten Beurteilungskriterien erkennbar ist, im Bereich der üblichen, zu erwartenden Werte, so daß die kontrollierte Fläche SQ bezüglich dieser Meßlinie LN als "gut" zu bewerten ist. Die Werte des Reflexionsgrades R weisen einen periodischen Verlauf auf. Dies rührt davon, daß heutzutage integrierte Halbleiterspeicher (ein solcher ist ja mit der vorliegenden Halbleiterscheibe WF, und somit mittels der betrachteten Flächen SQ zu fertigen) mehrere nebeneinander angeordnete Speicherzellenfelder aufweisen. Jede dargestellte Periode entspricht also einem solchen (künftigen) Speicherzellenfeld.

Die in Figur 8 mit "o" eingetragenen Werte des Reflexionsgrades R sind Meßwerte entlang einer zweiten Meßlinie LN beispielsweise derselben Fläche SQ. Auffallend dabei sind die Meßpunkte 4 und 11.

Der Wert des Reflexionsgrades R beim Meßpunkt 4 (d. h. innerhalb der ersten Periode) liegt deutlich oberhalb der sonstigen Meßpunkte, insbesondere auch bezüglich derer lokaler Maximalwerte innerhalb einer jeden der weiteren Perioden 2.... Hier liegt ein Fehler vor, der durch einen weißen Partikel verursacht ist. Weil ein weißer Partikel das Licht Lt besser abstrahlt als die sonstigen Stellen der Lackschicht L, ist dieser Wert besonders hoch.

Der Wert des Reflexionsgrades R bei Meßpunkt 11, der sich (zufälligerweise) am Übergang von der zweiten zur dritten Periode befindet, ist besonders niedrig, verglichen mit den restlichen Meßpunkten, insbesondere mit den minimalen Werten in den einzelnen Perioden. Dies läßt darauf schließen, daß an der betreffenden Stelle der Fläche SQ, die sich zwischen dem zweiten und dritten (noch herzustellenden) Speicherzellenfeld befindet, ein dunkler Partikel vorhanden ist. Es könnte jedoch auch sein, daß an dieser Stelle die Lackschicht L zu dünn ist oder gar ein Loch aufweist. Damit könnten bei der weiteren Herstellung des Speicherchips an dieser Stelle Strukturierungsfehler wie Unterätzen etc. auftreten. Auf jeden Fall zeigen die Meßwerte entlang der zweiten Meßlinie LN zwei Fehler auf, von denen jeder einzelne bei Erkennen zu einem entsprechenden Aussortieren der Halbleiterscheibe WF führt und ggf. zu Nacharbeiten.

Mit Hilfe der Meßpunkte 1, 2,... je Meßlinie LN wird also anhand von Beurteilungskriterien durch die Auswerteeinrichtung PC ermittelt, ob die untersuchte rechteckige Fläche SQ, und damit die gesamte Halbleiterscheibe WF, in Ordnung ist oder fehlerhaft. Die Ergebnisse (ggf. samt den geometrischen Daten, wo sich Fehler befinden) sind dann mittels der Auswerteeinrichtung PC ausgebbar z. B. in Form von Daten auf Speichermedien (Magnetbänder, Festplatte), durch Ausdrucken oder durch Ansteuern entsprechender Maschinen zur Nachbearbeitung. Es sind hier vielerlei Möglichkeiten vorstellbar.

Insbesondere folgende Beurteilungskriterien sind einsetzbar bei der Beurteilung, ob die kontrollierte Halbleiterscheibe WF bzw. deren rechteckige Flächen SQ in Ordnung sind oder nicht:
Es können, entweder für jede Meßlinie LN einer Fläche SQ getrennt, oder aber für alle Meßlinien LN der betreffenden Fläche SQ, die Maximalwerte des Reflexionsgrades R der einzelnen auftretenden Perioden ermittelt werden und daraufhin überprüft werden, ob sie sich um mehr als einen vorgegebenen, zulässigen Differenzwert voneinander unterscheiden. Ist dies der Fall, so wird ein Fehler angenommen; der betreffende Wert und die zugehörigen Koordinaten werden zwischengespeichert und ggf. ausgegeben oder weiterverarbeitet.

Dasselbe kann bezüglich der entsprechenden Minimalwerte des Reflexionsgrades R durchgeführt werden. Als weiteres Beurteilungskriterium kann folgendes durchgeführt werden: Es wird mittels der Auswerteeinrichtung PC bezüglich der kontrollierten Fläche SQ aus sämtlichen ermittelten Werten des Reflexionsgrades R entweder entlang einer einzigen Meßlinie LN oder entlang aller Meßlinien LN ein Mittelwert gebildet. Ein Abweichen dieses Mittelwertes um mehr als ein vorgegebenes Maß von einem vorgegebenen Wert wird als Fehler gewertet. Eine entsprechende Mittelwertbildung bezüglich der periodisch auftretenden Maximalwerte (oder aber auch der Minimalwerte) des Reflexionsgrades R in Verbindung mit einem Vergleich mit einem entsprechend vorgegebenen Wert und einer Überprüfung auf ein Abweichen von diesem Wert um mehr als ein vorgegebenes Maß ist ebenfalls eine günstiges Beurteilungskriterium.

Diese Beurteilungskriterien sind jeweils für sich allein anwendbar bei der Durchführung des erfindungsgemäßen Verfahrens. Sie sind jedoch auch in teilweiser oder vollständiger Kombination miteinander anwendbar.

In dem Fall, in dem vor der aktuell zu kontrollierenden Fläche SQ zuvor bereits eine andere rechteckige Fläche SQ derselben Halbleiterscheibe WF kontrolliert worden war, kann man auch folgendes Beurteilungskriterium verwenden: Man vergleicht jeweils einen, mehrere oder alle Werte des Reflexionsgrades R der Meßlinien LN der aktuellen Fläche SQ mit den entsprechenden Werten der entsprechenden Meßlinien LN der zuvor kontrollierten Fläche SQ. Ein Abweichen der jeweiligen Wertepaare voneinander um mehr als ein vorgegebenes Differenzmaß dient dann der Entscheidung, ob ein Fehler vorliegt oder nicht.

Weitere Beurteilungskriterien können sein anstelle des Vergleiches der jeweiligen Werte des Reflexionsgrades R, wie zuletzt beschrieben: Ein Vergleich der entsprechenden Maximalwerte miteinander, der entsprechenden Mittelwerte dieser Maximalwerte miteinander, ein Vergleich der entsprechenden Minimalwerte miteinander, ein Vergleich der jeweiligen Mittelwerte dieser Minimalwerte miteinander sowie ein Vergleich der jeweiligen Mittelwerte der Meßwerte miteinander. Als Entscheidung, ob ein Fehler vorliegt oder nicht, dient dann ein jeweils vorgegebenes Differenzmaß, bei dessen Überschreitung ein Fehler angenommen wird.

Wenn dann alle rechteckigen Flächen SQ der Halbleiterscheibe WF mittels des geschilderten Verfahrens kontrolliert sind, und entsprechende Aussagen über die kontrollierte Scheibe WF getroffen wurden, so ist der erste Abschnitt des erfindungsgemäßen Verfahrens beendet. Danach werden Grundzüge dieses Verfahrens abschnitts unter veränderten Bedingungen insbesondere auf die zuvor als gut erkannten Flächen SQ der Halbleiterscheibe WF nochmals angewendet mittels einer anderen Vorrichtung zur Durchführung dieses Verfahrens. Dabei können diejenigen Verfahrensschritte, die dem Erkennen und Identifizieren der zu kontrollierenden rechteckigen Flächen SQ und der von der Kontrolle auszunehmenden Bereiche U dienen, wiederholt werden. Sie können jedoch auch weggelassen werden, wenn die Koordinaten X, Y der zu kontrollierenden Flächen SQ vom zuvor beschriebenen Verfahren her übernommen werden und eine entsprechende Justierung der Halbleiterscheibe WF mit ihrem Flat Ft bezüglich der Einrichtung E vorgenommen wird, da die Koordinaten X, Y bezüglich des Flats Ft in der Auswerteeinrichtung PC gespeichert sind. Zunächst wird die für diese erneute Durchführung des Verfahrens benötigte Vorrichtung erläutert anhand von Figur 2.

Diese Vorrichtung ist ähnlich aufgebaut wie die eingangs vorgestellte Vorrichtung. Sie unterscheidet sich jedoch in einigen Punkten deutlich von dieser.

Sie weist ebenfalls eine Einrichtung E auf zur Aufnahme der zu kontrollierenden Halbleiterscheibe WF sowie eine Beleuchtungseinrichtung Lt2. Diese dient jedoch einer indirekten Beleuchtung der Halbleiterscheibe WF. D. h., die Halbleiterscheibe WF wird unter einem steilen Winkel zur Oberfläche der Halbleiterscheibe WF beleuchtet, wie anhand eines Lichtstrahls Lt aus Figur 2 ersichtlich. Außerdem ist auch die bereits vorgestellte halbkugelförmige Abdeckeinrichtung HK vorhanden, allerding mit einer Oberfläche K2 in ihrem Inneren, welche auftreffendes Licht Lt in hohem Maße reflektiert. Sie ist deshalb vorzugsweise weiß. Weiterhin ist zwischen der Beleuchtungseinrichtung Lt2 und der Einrichtung E zur Aufnahme der zu kontrollierenden Halbleiterscheibe WF eine weitere, auftreffendes Licht Lt absorbierende Abdeckeinrichtung K angeordnet, die so ausgebildet ist, daß sie direkten Lichteinfall auf die Einrichtung E samt der Halbleiterscheibe WF verhindert, d.h., die Halbleiterscheibe WF ist lediglich indirekt beleuchtbar mit der Beleuchtungseinrichtung Lt2 durch Reflexion des Lichtes Lt an der halbkugelförmigen Abdeckeinrichtung HK. An der halbkugelförmigen Abdeckung HK ist auch eine Kamera CAM so angeordnet, daß ihr Objektiv Obj in den Raum Rm innerhalb der halbkugelförmigen Abdeckeinrichtung HK blickt. Bezüglich des Mittelpunktes der Einrichtung E zur Aufnahme der Halbleiterscheibe WF ist die Kamera CAM jedoch nicht senkrecht angeordnet wie bei der ersten Ausführungsform nach Figur 1, sondern in einem Winkel α, der größer als 0° ist und kleiner als 90°. Als gut hat sich eine Winkelstellung von 40° bis 70° erwiesen bei einem optimalen Wert von 60°. In diesem Fall kann sich nämlich die Kamera weder direkt noch indirekt auf der Halbleiterscheibe WF spiegeln, was ein Erfassen der Werte des Reflexionsgrades R stören würde.

Weiterhin ist es günstig, wenn das Objektiv Obj der Kamera CAM mit einem Rotfilter F ausgerüstet ist, welches den Kontrast des empfangenen Bildes steigert.

Die Kamera CAM ist, wie auch bei der ersten Ausführungsform, mit einer Auswerteeinrichtung PC verbunden, die der Steuerung der Kamera CAM dient sowie zum Empfang, zur Verarbeitung, zur Zwischenspeicherung und zur Ausgabe der von der Kamera CAM übermittelten Daten bzw. Bilder.

Folgende weitere Ausgestaltungen sind bei beiden Vorrichtungen (d.h. Vorrichtungen nach den Figuren 1 und 2) vorteilhaft:
Das Licht der Beleuchtungseinrichtungen Lt1 bzw. Lt2 ist weiß. Die weiteren Abdeckeinrichtungen K weisen eine schwarze Oberfläche auf. Innerhalb der halbkugelförmigen Abdeckeinrichtung HK befindliche weitere Teile der Kamera CAM sind, soweit überhaupt vorhanden, so angeordnet, daß diese, von der Halbleiterscheibe WF bzw. der Einrichtung E her betrachtet, durch das Objektiv Obj verdeckt sind. Weiterhin ist es vorteilhaft im Sinne einer gleichmäßigen Ausleuchtung, wenn die Beleuchtungseinrichtungen Lt1 bzw. Lt2 und/oder die weiteren Abdeckungen K ringförmig sind. Eine Bodenplatte Pl ist auch bei der zweiten Vorrichtung nicht unbedingt notwendig (außer vielleicht aus mechanischen Gründen, aus Stabilitätsgründen oder aus Gründen einer einfacheren Bildverarbeitung). Soweit sie jedoch vorhanden ist, sollte sie schwarz sein.

Mit der so modifizierten zweiten Vorrichtung läßt sich nun anschließend an das vorstehend beschriebene Verfahren noch das folgende Verfahren anschließen:
Die (in einem zweiten Durchlauf zu kontrollierende) Halbleiterscheibe WF wird mittels der Beleuchtungseinrichtung Lt2 und der halbkugelförmigen Abdeckeinrichtung HK mit ihrer reflektierenden Oberfläche K2 indirekt beleuchtet. Aufgrund der im Winkel α angeordneten Kamera CAM erscheinen nunmehr die rechteckigen Flächen SQ mit ihren Koordinaten X1, Y1 verzerrt gegenüber der ersten Anordnung. Die Verzerrungen werden durch die Auswerteeinrichtung PC aus dem Winkel α der Kamerastellung und aus den ursprünglichen Koordinaten X, Y berechnet. Mit Hilfe dieser berechneten, verzerrten Koordinaten X1, Y1 für jede Fläche SQ wird nun das eingangs beschriebene Verfahren erneut durchgeführt, soweit es die Kontrolle der rechteckigen Flächen SQ selbst betrifft (also nicht die ersten Schritte, welche der Ermittlung der Flächen SQ und deren Koordinaten X, Y betreffen). Dabei können die selben Bewertungskriterien angewandt werden wie zuvor bereits geschildert.

Es ist vorteilhaft, da rechenzeitsparend und somit den Arbeitsablauf verkürzend, wenn dieses modifizierte Verfahren mit schräggestellter Kamera CAM nur auf solche Flächen SQ angewandt wird, die beim eingangs geschilderten Verfahren mit senkrecht stehender Kamera als gut befunden worden sind.

Wenn auch dieser weitere Verfahrensabschnitt Zeit kostet, so hat diese Auführungsform doch folgenden, wesentlichen Vorteil: Es ergibt Defekte in der und/oder unterhalb der Lackschicht L, die bei senkrecht stehender Kamera CAM und/oder bei direkter Bestrahlung der Halbleiterscheibe WF nicht sichtbar gemacht werden können und damit nicht erkennbar sind. Mit diesem weiteren Verfahrens abschnitt, d.h. unter indirekter Beleuchtung und mittels schräg gestellter Kamera CAM lassen sich jedoch auch diese Defekte in den meisten Fällen erkennen, so daß rechtzeitige Nacharbeiten der betreffenden Halbleiterscheiben WF möglich sind, was wiederum die Ausbeute an den zu fertigenden Halbleiterspeichern steigert und damit die Produktionskosten insgesamt senkt.

Eine dritte Ausführungsform der Vorrichtung zur Durchführung des Verfahrens ermöglicht, sämtliche oben genannten Verfahrensschritte, d.h. sowohl diejenigen, bei denen die Kamera CAM senkrecht steht, als auch diejenigen, bei denen die Kamera CAM schräg in einem Winkel α angeordnet ist, mittels einer einzigen Vorrichtung, nämlich dieser dritten Ausführungsform, durchzuführen. Diese Vorrichtung wird anhand von Figur 3 nachstehend beschrieben.

Die Vorrichtung weist wiederum eine Einrichtung E auf zur Aufnahme der zu kontrollierenden Halbleiterscheibe WF. Sie hat zwei Beleuchtungseinrichtungen Lt1, Lt2, wovon die erste (Lt1) einer direkten Beleuchtung der Halbleiterscheibe WF mit einer ersten Farbe Gn dient, die vorzugsweise grün ist und wovon die zweite Beleuchtungseinrichtung Lt2 einer indirekten Beleuchtung der Halbleiterscheibe WF dient mit einer zweiten Farbe Rt, die zur ersten Farbe Gn komplementär ist. Die zweite Farbe Rt ist vorzugsweise rot. Eine halbkugelförmige Abdeckeinrichtung HK, die ebenfalls Bestandteil dieser dritten Vorrichtung ist, hat in ihrem Innenraum Rm eine Oberfläche K3, die ebenfalls von der zweiten Farbe Rt ist, also vorzugsweise rot. Die halbkugelförmige Abdeckung HK bildet mittels einer auch bei dieser Ausführungsform nur optional vorhandenen Bodenplatte Pl einen weitgehend geschlossenen Innenraum Rm. Diese Bodenplatte Pl kann auf ihrer dem Innenraum Rm zugewandten Oberfläche die zweite Farbe Rt aufweisen, also vorzugsweise rot. Die Oberfläche könnte in einer anderen Ausgestaltung jedoch auch schwarz sein. Oberhalb der ersten Beleuchtungseinrichtung Lt1 ist eine weitere, für auftreffendes Licht Lt undurchlässige Abdeckeinrichtung K angeordnet. Es ist günstig, wenn die Abdeckeinrichtung K lichtabsorbierend ist. Sie ist so ausgebildet, daß einerseits die Halbleiterscheibe WF mittels der ersten Beleuchtungseinrichtung Lt1 direkt beleuchtbar ist und daß andererseits diese Halbleiterscheibe WF durch die zweite Beleuchtungseinrichtung Lt2 lediglich indirekt beleuchtbar ist.

Senkrecht oberhalb des Mittelpunktes der Einrichtung E zur Aufnahme der Halbleiterscheibe WF ist an der halbkugelförmigen Abdeckeinrichtung HK eine erste Kamera CAM1 so angeordnet, so daß ihr Objektiv Obj in den Innenraum Rm innerhalb der halbkugelförmigen Abdeckeinrichtung HK und dort auf die Einrichtung E blickt. Die erste Kamera CAM1 weist ein Filter F1 auf, welches nur Licht der ersten Farbe Gn, also vorzugsweise grünes Licht passieren läßt (= Grünfilter).

Des weiteren ist an der halbkugelförmigen Abdeckeinrichtung HK eine Kamera CAM2 so angeordnet, daß ihr Objektiv Obj in den Innenraum Rm innerhalb der halbkugelförmigen Abdeckeinrichtung HK ragt und dort auf die Einrichtung E blickt. Auch die zweite Kamera CAM2 weist ein Filter F2 auf, welches allerdings nur Licht der zweiten Farbe Rt, also vorzugsweise rotes Licht passieren läßt (= Rotfilter).

Die zweite Kamera CAM2 ist bezüglich des Mittelpunktes der Einrichtung E in einem Winkel α angeordnet, der größer als 0° ist und maximal so groß ist, daß die zweite Kamera CAM2 mit der ersten Kamera CAM1 nicht in Berührung kommt.

Beide Kameras CAM1, CAM2 sind mit einer Auswerteeinrichtung PC verbunden, die der Steuerung der Kameras CAM1, CAM2 dient sowie zur Erfassung, zur Zwischenspeicherung, zur Weiterverarbeitung und zur Ausgabe von von den Kameras CAM1, CAM2 erhaltenen Daten bzw. Bildern.

Diese dritte Ausführungsform der Vorrichtung ist nun folgendermaßen mittels des erfindungsgemäßen Verfahrens einsetzbar:
Für die ersten Verfahrensschritte, die dem Erkennen und Erfassen der einzelnen rechteckigen Flächen SQ samt ihren Koordinaten X, Y dient, und die zweiten Verfahrensschritte, die dem eigentlichen Kontrollieren der Flächen SQ und damit der Halbleiterscheiben WF mittels senkrecht stehender Kamera (CAM bei der ersten Ausführungsform der Vorrichtung) dient, werden die zu kontrollierenden Halbleiterscheiben WF mittels der ersten Beleuchtungseinrichtung Lt1 und der ersten, senkrecht stehenden Kamera CAM1 in bereits beschriebener Weise kontrolliert.

Anschließend daran werden für die zuletzt beschriebenen Verfahrensschritte, welche anhand der zweiten Ausführungsform der Vorrichtung beschrieben wurden (d.h. also, die mittels indirekter Beleuchtung der Halbleiterscheiben WF und schräggestellter Kamera CAM durchgeführt werden), die erste Beleuchtungseinrichtung Lt1 und die erste Kamera CAM1 abgeschaltet und stattdessen wird das Verfahren mittels der indirekten Beleuchtung (d.h. die Beleuchtung erfolgt durch die zweite Beleuchtungseinrichtung Lt2) und der zweiten, schräggestellten Kamera CAM2 durchgeführt entsprechend den zuvor hinsichtlich der zweiten Ausführungsform der Vorrichtung beschriebenen Verfahrensschritten.

Damit sich die beiden verschiedenen Beleuchtungsarten (direkte und indirekte Beleuchtung) mit ihren Lichtbedingungen einschließlich auftretender bzw. zu unterbindender Reflexionen unter anderem an der halbkugelförmigen Abdeckeinrichtung HK möglichst wenig gegenseitig beeinflussen, wurde das System mit den zueinander komplementären Farben Gn, Rt der Beleuchtungseinrichtungen Lt1, Lt2 und den entsprechend gestalteten Oberflächen der halbkugelförmigen Abdeckeinrichtung HK sowie ggf. der Bodenplatte Pl gewählt.

Weiterhin ist es günstig, wenn bei einer der beiden Kameras CAM1, CAM2 oder bei beiden Kameras CAM1, CAM2 im Innenraum Rm innerhalb der halbkugelförmigen Abdeckeinrichtung HK befindliche Teile der Kameras CAM1 und/oder CAM2 so angeordnet sind, daß sie, von der Halbleiterscheibe WF bzw. der Einrichtung E her betrachtet, durch das Objektiv Obj der jeweiligen Kamera CAM1, CAM2 verdeckt sind.

Darüber hinaus ist es vorteilhaft, wenn wenigstens eine der beiden Beleuchtungseinrichtungen Lt1, Lt2 und/oder die weitere Abdeckeinrichtung K ringförmig ist bzw. angeordnet ist.

Auch die Einrichtung E zur Aufnahme der Halbleiterscheiben WF kann auf verschiedene Arten vorteilhaft ausgestaltet sein: Als Bestandteil der Bodenplatte Pl, angeordnet auf der Bodenplatte Pl oder in diese (Pl) eingelassen.

Ebenso ist es vorteilhaft (entsprechend der zweiten Vorrichtung), wenn der Winkel α, in dem die zweite Kamera CAM2 bezüglich des Mittelpunktes der Einrichtung E angeordnet ist, 40° bis 70° beträgt. Optimal ist eine Anordnung von 60°.

## Patentansprüche

1. Verfahren zur Kontrolle von Halbleiterscheiben (WF), die zur Fertigung integrierter Halbleiterspeicher dienen, bei der die Halbleiterscheiben (WF) eine Lackschicht (L) aufweisen, unterhalb derer sich bereits wenigstens eine Schicht mit Strukturen (St) befindet, die folgende Merkmale aufweisen:
- die Strukturen (St) sind rechteckig, parallel ausgerichtet und periodisch in einem zwei-dimensionalen Array auf den Halbleiterscheiben (WF) angeordnet,
- die Strukturen (St) sind zum großen Teil regelmäßig und entsprechen in diesen Teilen den zu kontrollierenden Flächen (SQ),
- die Flächen (SQ) weisen hohe Reflexionsgrade (R) auf, der unregelmäßige Teil der Strukturen (St) und die dazwischenliegenden Ritz-Rahmen weisen deutlich niedrigere Werte des Reflexionsgrades (R) auf;
- die Kontrolle wird automatisch mit folgenden Verfahrensschritten durchgeführt:
1) wenigstens bei der ersten zu kontrollierenden Halbleiterscheibe (WF) werden Bereiche (U) ermittelt, die von der Kontrolle auszunehmen sind und Flächen (SQ), die zu kontrollieren sind, gemäß den folgenden Schritten:
1a) die Halbleiterscheibe (WF) wird unter einem flachen Winkel zur Oberfläche der Halbleiterscheibe (WF) beleuchtet, so daß die aufgebrachte Lackschicht (L) das Licht (Lt) reflektiert,
1b) mittels einer Kamera (CAM), die senkrecht über der Halbleiterscheibe (WF) angeordnet ist, und einer daran angeschlossenen Auswerteeinrichtung (PC) wird der Reflexionsgrad (R) des reflektierten Lichtes (Lt) auf folgende Weise ermittelt und zwischengespeichert:
1b1) bezüglich des Reflexionsgrades (R) werden ein Mindestwert (Rmin) und ein Maximalwert (Rmax) vorgegeben,
1b2) längs zweier gedachter, über die Halbleiterscheibe (WF) zeitlich nacheinander gezogener Linien (LNx, LNy), die senkrecht zueinander stehen und von denen die zuerst gezogene Linie (LNx) am Vorlauf der Strukturen (St) ausgerichtet ist, wird der Reflexionsgrad (R) des reflektierten Lichtes (Lt) an ausgewählten Punkten (Px, Py) der gedachten Linien (LNx, LNy) ermittelt und zwischengespeichert,
1b3) ergeben sich bei wenigstens einer der gedachten Linien (LNx; LNy) mehrheitlich Werte des Reflexionsgrades (R), welche unterhalb des vorgegebenen Mindestwertes (Rmin) liegen, so wird Schritt 1b2) wiederholt bezüglich einer weiteren gedachten Linie (LNx1; LNy1), welche im Abstand parallel zu der gedachten Linie (LNx; LNy) verläuft, welche mehrheitlich Werte des Reflexions grads unterhalb des Mindestwertes (Rmin) aufweist,
1b4) führt auch Schritt 1b3) bezüglich der weiteren gedachten Linie (LNx1; LNy1) mehrheitlich zu Werten des Reflexionsgrades (R), welche unterhalb des Mindestwertes (Rmin) liegen, so wird Schritt 1b3) so oft wiederholt mittels jeweils nochmals weiterer gedachter Linien (LNX2,...;LNy2,...), die im Abstand zur jeweils zuletzt vermessenen gedachten Linie (LNx2,...;LNy2,...) liegen, bis eine gedachte Linie (LNx2,...;LNy2,...) gefunden ist, deren Werte des Reflexionsgrades (R) mehrheitlich das Kriterium des Mindestwertes (Rmin) erfüllen,
1c) führen die Schritte 1b1) bis 1b4) nicht zu zwei senkrecht zueinander stehenden gedachten Linien (LNx,...;LNy,...), welche das Kriterium des Mindestwertes (Rmin) erfüllen, so wird die Kontrolle abgebrochen, ansonsten werden bezüglich jeder der beiden gedachten Linien (LNx, LNy) aus deren Lagepunkten (x; y), den zugehörigen Werten des Reflexionsgrades (R) sowie der Information, daß die Halbleiterscheibe (WF) regelmäßige, rechteckige, in einem zwei-dimensionalen Array angeordnete Strukturen (SQ) mit einem hohen Wert des Reflexionsgrades (R) aufweist, diejenigen Koordinaten (X, Y) ermittelt, die oberhalb eines vorgegebenen Maximalwertes (Rmax) liegen, jedoch in Nachbarschaft sind zu Lagewerten (x; y), deren Reflexionsgrad (R) unterhalb des Maximalwertes (Rmax) liegt,
1d) die Menge der so gefundenen Koordinaten (X, Y) wird dazu verwendet, im weiteren Verfahren Bereiche (U) der zu kontrollierenden Halbleiterscheibe (WF) von der Kontrolle auszunehmen, die Reflexionsgrade (R) aufweisen, deren Werte unterhalb des Maximalwertes (Rmax) liegen, so daß sich für die zu kontrollierende Halbleiterscheibe (WF) eine Vielzahl von zu kontrollierenden Flächen (SQ) ergibt, bei denen die Koordinaten ihrer jeweiligen Eckpunkte (A, B, C, D) gleich den ermittelten jeweiligen Koordinaten (X, Y) ist,
2) die Kontrolle einer jeden Fläche (SQ) erfolgt bei weiter bestehender Beleuchtung mit folgenden Verfahrensschritten:
2a) es wird wenigstens eine gedachte Meßlinie (LN) durch die zu kontrollierende Fläche (SQ) gelegt,
2b) entlang dieser Meßlinie (LN) wird an vorgegebenen Meßpunkten (1, 2, 3,...) der jeweilige Wert des Reflexionsgrades (R) des reflektierten Lichtes (Lt) mittels der Kamera (CAM) und der Auswerteeinrichtung (PC) ermittelt und zwischengespeichert,
2c) zur Erkennung eines einzelnen Fehlers oder mehrerer Fehler werden mehrere der entlang der Meßlinie (LN) gemessenen und zwischengespeicherten Werte des Reflexionsgrades (R) herangezogen, aus diesen Werten werden auftretende Maximal- oder Minimalwerte bestimmt oder Mittelwerte berechnet, wobei mittels dieser Werte anhand eines vorgegebenen Beurteilungskriteriums Aussagen darüber getroffen werden, ob die kontrollierte Fläche (SQ) in Ordnung oder fehlerhaft ist,
2d) als fehlerhaft befundene Flächen (SQ) werden ermittelt;
3) für die nachfolgende ergänzende Kontrolle einer jeden Fläche (SQ) gemäß Schritten 2a) bis 2d)
- wird die Halbleiterscheibe (WF) unter einem steilen Winkel zur Oberfläche der Halbleiterscheibe (WF) beleuchtet,
- die Kamera (CAM) wird in einem Winkel (α) größer 0° und kleiner 90° zur Oberfläche der Halbleiterscheibe (WF) angeordnet,
- die sich aus dieser Anordnung der Kamera ergebenden Verzerrungen bezüglich der Koordinaten (X1, Y1) der Flächen (SQ) werden aus den ursprünglich ermittelten Koordinaten (X, Y) der Flächen (SQ) und dem gewählten Winkel (α) der Kamera (CAM) berechnet, und
- unter Zugrundelegen dieser berechneten Koordinaten (X1, Y1) werden die Verfahrensschritte gemäß den Merkmalen 2) bis 2d) durchgeführt.

2. Verfahren nach Anspruch 1,
**dadurch gekennzeichnet, daß** bei einer Verwendung einer Charge von Halbleiterscheiben (HL) für die zweite und weiteren Halbleiterscheiben (WF) derselben Charge von Halbleiterscheiben (WF) anstelle des Ermittelns der Koordinaten (X, Y) der Eckpunkte (A, B, C, D) ihrer Flächen (SQ) gemäß den Schritten nach den Merkmalen 1) bis 1d) von Anspruch 1 die für die erste Scheibe (WF) der Charge ermittelten entsprechenden Koordinaten (X, Y) für die Kontrolle der Flächen (SQ) der aktuellen Halbleiterscheibe (WF) zugrunde gelegt werden.

3. Verfahren nach einem der Ansprüche 1 oder 2,
**dadurch gekennzeichnet, daß** nur solche Flächen (SQ) mittels der im Winkel (α) angeordneten Kamera (CAM) kontrolliert werden, die bei der Kontrolle mittels der senkrecht stehenden Kamera (CAM) als in Ordnung befindlich erkannt worden sind.

4. Verfahren nach einem der Ansprüche 1 bis 3,
**dadurch gekennzeichnet, daß**
als Beurteilungskriterium für die zu kontrollierende Fläche (SQ) die periodisch auftretenden Maximalwerte des Reflexionsgrades (R) verwendet werden, und ein Abweichen dieser Maximalwerte voneinander um mehr als einen vorgegebenen Differenzwert wird als fehlerhaft bewertet bezüglich der zu kontrollierenden Fläche (SQ).

5. Verfahren nach einem der Ansprüche 1 bis 3,
**dadurch gekennzeichnet, daß**
als Beurteilungskriterium für die zu kontrollierende Fläche (SQ) aus sämtlichen ermittelten Werten des Reflexionsgrades (R) entlang einer oder aller Meßlinien (LN) einer Fläche (SQ) ein Mittelwert gebildet wird, und ein Abweichen dieses Mittelwertes von einem vorgegebenen Wert um mehr als ein vorgegebenes Maß wird als fehlerhaft bewertet bezüglich der zu kontrollierenden Fläche (SQ).

6. Verfahren nach einem der Ansprüche 1 bis 3,
**dadurch gekennzeichnet, daß**
als Beurteilungskriterium für die zu kontrollierende Fläche (SQ) aus den periodisch auftretenden Maximalwerten des Reflexionsgrades (R) entlang einer oder aller Meßlinien (LN) einer Fläche (SQ) ein Mittelwert gebildet wird, und ein Abweichen dieses Mittelwertes von einem vorgegebenen Wert um mehr als ein vorgegebenes Maß wird als fehlerhaft bewertet bezüglich der zu kontrollierenden Fläche (SQ).

7. Verfahren nach einem der Ansprüche 1 bis 3,
**dadurch gekennzeichnet, daß**
als Beurteilungskriterium für die zu kontrollierende Fläche (SQ) die periodisch auftretenden Minimalwerte des Reflexionsgrades (R) verwendet werden, und ein Abweichen dieser Minimalwerte voneinander von mehr als einen vorgegebenen Differenzwert wird als fehlerhaft bewertet bezüglich der zu kontrollierenden Fläche (SQ).

8. Verfahren nach einem der Ansprüche 1 bis 3,
**dadurch gekennzeichnet, daß**
als Beurteilungskriterium für die zu kontrollierende Fläche (SQ) wenigstens ein Teil der ermittelten Werte des Reflexionsgrades (R) mit einem entsprechenden Teil der jeweiligen ermittelten Werte der vor der aktuell zu kontrollierenden Fläche (SQ) bereits kontrollierten Fläche (SQ-1) verglichen wird, und als Beurteilungskriterium wird ein Abweichen der so miteinander verglichenen Werte um ein vorgegebenes Differenzmaß verwendet.

9. Verfahren nach einem der Ansprüche 1 bis 3 und Anspruch 8,
**dadurch gekennzeichnet, daß**
als Beurteilungskriterium für die zu kontrollierende Fläche (SQ) dre Periodisch auftretenden Maximalwerte des Reflexionsgrades (R) dieser Fläche (SQ) und der vor dieser Fläche (SQ) kontrollierten Fläche (SQ-1) verwendet werden, und ein Abweichen der jeweiligen Maximalwerte voneinander um mehr als ein vorgegebenes Maß wird als fehlerhaft bewertet bezüglich der zu kontrollierenden Fläche (SQ).

10. Verfahren nach einem der Ansprüche 1 bis 3 und Anspruch 8,
**dadurch gekennzeichnet, daß**
als Beurteilungskriterium für die zu kontrollierende Fläche (SQ) aus sämtlichen ermittelten Werten des Reflexionsgrades (R) entlang einer oder aller Meßlinien (LN) dieser Fläche (SQ) und der vor dieser Fläche (SQ) kontrollierten Fläche (SQ-1) ein Mittelwert gebildet wird, und ein Abweichen der Mittelwerte der jeweiligen Werte des Reflexionsgrades (R) voneinander um mehr als ein vorgegebenes Maß wird als fehlerhaft bewertet bezüglich der zu kontrollierenden Fläche (SQ).

11. Verfahren nach einem der Ansprüche 1 bis 3 und Anspruch 8,
**dadurch gekennzeichnet, daß**
als Beurteilungskriterium für die zu kontrollierende Fläche (SQ) aus den periodisch auftretenden Maximalwerten oder Minimalwerten des Reflexionsgrades (R) entlang einer oder aller Meßlinien (LN) dieser Fläche (SQ) und der vor dieser Fläche (SQ) kontrollierten Fläche (SQ-1) ein Mittelwert gebildet wird, und ein Abweichen der aus den jeweiligen periodisch auftretenden Maximalwerten oder Minimalwerten gebildeten Mittelwerte voneinander um mehr als ein vorgegebenes Maß wird als fehlerhaft bewertet bezüglich der zu kontrollierenden Fläche (SQ).

12. Verfahren nach einem der Ansprüche 1 bis 3 und Anspruch 8,
**dadurch gekennzeichnet, daß**
als Beurteilungskriterium für die zu kontrollierende Fläche (SQ) die periodisch auftretenden Minimalwerte des Reflexionsgrades (R) dieser Fläche (SQ) und der vor dieser Fläche (SQ) kontrollierten Fläche (SQ-1) verwendet werden, und ein Abweichen der jeweiligen Minimalwerte voneinander um mehr als ein vorgegebenes Maß wird als fehlerhaft bewertet bezüglich der zu kontrollierenden Fläche (SQ).

13. Verfahren nach einem der Ansprüche 1 bis 12,
**dadurch gekennzeichnet, daß** die gedachte Meßlinie (LN) parallel zur längeren Kante der zu kontrollierenden Fläche (SQ) gelegt wird.

14. Verfahren nach einem der Ansprüche 1 bis 12,
**dadurch gekennzeichnet, daß** die gedachte Meßlinie (LN) parallel zur kürzeren Kante der zu kontrollierenden Fläche (SQ) gelegt wird.

15. Verfahren nach einem der vorhergehenden Ansprüche,
**dadurch gekennzeichnet, daß** die zu kontrollierende Fläche (SQ) mittels mehr als einer Meßlinie (LN) kontrolliert wird.

## Claims

1. Method for inspecting semiconductor wafers (WF) which serve for fabricating integrated semiconductor memories, in which the semiconductor wafers (WF) have a resist layer (L) below which there is already situated at least one layer having structures (St) which have the following features:
- the structures (St) are rectangular, oriented parallel and arranged periodically in a two-dimensional array on the semiconductor wafers (WF),
- the structures (St) are for the most part regular and correspond in these parts to the areas (SQ) to be inspected,
- the areas (SQ) have high reflection factors (R), the irregular part of the structures (St) and the intervening scribe lines have distinctly lower values of the reflection factor (R);
- the inspection is carried out automatically using the following method steps:
1) at least in the case of the first semiconductor wafer (WF) to be inspected, regions (U) which are to be excluded from the inspection are determined and areas (SQ) which are to be inspected are determined, in accordance with the following steps:
1a) the semiconductor wafer (WF) is illuminated at a shallow angle with respect to the surface of the semiconductor wafer (WF), so that the applied resist layer (L) reflects the light (Lt),
1b) using a camera (CAM), arranged perpendicularly above the semiconductor wafer (WF), and an evaluation device (PC) connected to the said camera, the reflection factor (R) of the reflected light (Lt) is determined and buffer-stored in the following way:
1b1) a minimum value (Rmin) and a maximum value (Rmax) are prescribed with regard to the reflection factor (R),
1b2) along two imaginary lines (LNx, LNy), which are drawn temporally successively- across the semiconductor wafer (WF) and are perpendicular to one another and of which the line (LNx) drawn first is oriented to the advance of the structures (St), the reflection factor (R) of the reflected light (Lt) is determined at selected points (Px, Py) on the imaginary lines (LNx, LNy) and buffer-stored,
1b3) if the majority of values of the reflection factor (R) lie below the prescribed minimum value (Rmin) in the case of at least one of the imaginary lines (LNx; LNy), then step 1b2) is repeated with regard to a further imaginary line (LNx1; LNy1), which runs at a distance from and parallel to the imaginary line (LNx; LNy) which has the majority of values of the reflection factor below the minimum value (Rmin),
1b4) if step 1b3) with regard to the further imaginary line (LNx1; LNy1) also leads to a majority of values of the reflection factor (R) lying below the minimum value (Rmin), then step lb3) is repeated as often as necessary, in each case again using further imaginary lines (LNx2,...; LNy2,...), which are at a distance from the imaginary line (LNx2,...; LNy2,...) measured last in each case, until an imaginary line (LNx2,...; LNY2,...) has been found the majority of whose values of the reflection factor (R) satisfy the criterion of the minimum value (Rmin),
1c) if the steps 1b1) to 1b4) do not lead to two imaginary lines (LNx,...; LNy,...) which are perpendicular to one another and satisfy the criterion of the minimum value (Rmin), then the inspection is terminated; otherwise, with regard to each of the two imaginary lines (LNx, LNy), from their position points (x; y), the associated values of the reflection factor (R) and also the information that the semiconductor wafer (WF) has regular, rectangular structures (SQ) - arranged in a two-dimensional array - with a high value of the reflection factor (R), those coordinates (X, Y) are determined which lie above a prescribed maximum value (Rmax) but are in proximity to position values (x; y) whose reflection factor (R) lies below the maximum value (Rmax),
1d) the set of the coordinates (X, Y) found in this way is used, as the method proceeds, to exclude from the. inspection regions (U) of the semiconductor wafer (WF) to be inspected which have reflection factors (R) whose values lie below the maximum value (Rmax), thereby producing, for the semiconductor wafer (WF) to be inspected, a multiplicity of areas (SQ) to be inspected in which the coordinates of their respective corner points (A, B, C, D) are identical to the respective coordinates (X, Y) determined,
2) the inspection of each area (SQ) is effected, with continuing illumination, using the following method steps:
2a) at least one imaginary measurement line (LN) is drawn through the area (SQ) to be inspected,
2b) along this measurement line (LN), at prescribed measurement points (1, 2, 3,...), the respective value of the reflection factor (R) of the reflected light (Lt) is determined by means of the camera (CAM) and the evaluation device (PC) and buffer-stored,
2c) in order to identify an individual defect or a plurality of defects, use is made of a plurality of the values of the reflection factor (R) which are measured along the measurement line (LN) and buffer-stored, from these values maximum or minimum values that occur are determined or average values are calculated, statements about whether the inspected area. (SQ) is in order or defective being made using these values and using a prescribed assessment criterion,
2d) areas (SQ) found to be defective are determined;
3) for the subsequent supplementary inspection of each area (SQ) in accordance with steps 2a) to 2d),
- the semiconductor wafer (WF) is illuminated at a steep angle with respect to the surface of the semiconductor wafer (WF),
- the camera (CAM) is arranged at an angle (α) of greater than 0° and less than 90° with respect to the surface of the semiconductor wafer (WF),
- the distortions with regard to the coordinates (X1, Y1) of the areas (SQ) which result from this arrangement of the camera are calculated from the originally determined coordinates (X, Y) of the areas (SQ) and the chosen angle (α) of the camera (CAM), and
- taking these calculated coordinates (X1, Y1) as a basis, the method steps in accordance with features 2) to 2d) are carried out.

2. Method according to Claim 1,
**characterized in that** in the case of the use of a batch of semiconductor wafers (HL), for the second and further semiconductor wafers (WF) of the same batch of semiconductor wafers (WF), instead of determining the coordinates (X, Y) of the corner points (A, B, C, D) of their areas (SQ) in accordance with the steps according to features 1) to 1d) of Claim 1, the corresponding coordinates (X, Y) determined for the first wafer (WF) of the batch are taken as a basis for the inspection of the areas (SQ) of the current semiconductor wafer (WF).

3. Method according to either of Claims 1 and 2,
**characterized in that** the only areas (SQ) which are inspected by means of the camera (CAM) arranged at the angle (α) are those which were identified as being in order during the inspection by means of the perpendicular camera (CAM).

4. Method according to one of Claims 1 to 3,
**characterized in that**
the periodically occurring maximum values of the reflection factor (R) are used as the assessment criterion for the area (SQ) to be inspected, and a deviation of these maximum values from one another by more than a prescribed difference value is evaluated as defective with regard to the area (SQ) to be inspected.

5. Method according to one of Claims 1 to 3,
**characterized in that**,
as the assessment criterion for the area (SQ) to be inspected, an average value is formed from all the values of the reflection factor (R) that are determined along one or all measurement lines (LN) of an area (SQ), and a deviation of this average value from a prescribed value by more than a prescribed amount is evaluated as defective with regard to the area (SQ) to be inspected.

6. Method according to one of Claims 1 to 3,
**characterized in that**,
as the assessment criterion for the area (SQ) to be inspected, an average value is formed from the periodically occurring maximum values of the reflection factor (R) along one or all measurement lines (LN) of an area (SQ), and a deviation of this average value from a prescribed value by more than a prescribed amount is evaluated as defective with regard to the area (SQ) to be inspected.

7. Method according to one of Claims 1 to 3,
**characterized in that**
the periodically occurring minimum values of the reflection factor (R) are used as the assessment criterion for the area (SQ) to be inspected, and a deviation of these minimum values from one another by more than a prescribed difference value is evaluated as defective with regard to the area (SQ) to be inspected.

8. Method according to one of Claims 1 to 3,
**characterized in that**,
as the assessment criterion for the area (SQ) to be inspected, at least a portion of the values of the reflection factor (R) that are determined is compared with a corresponding portion of the respective values that are determined for the area (SQ-1) that has already been inspected before the area (SQ) that is currently to be inspected, and a deviation of the values that are compared to one another in this way by a prescribed difference amount is used as the assessment criterion.

9. Method according to one of Claims 1 to 3 and Claim 8,
**characterized in that**
the periodically occurring maximum values of the reflection factor (R) of the area (SQ) to be inspected and of the area (SQ-1) that was inspected before this area (SQ) are used as the assessment criterion for this area (SQ), and a deviation of the respective maximum values from one another by more than a prescribed amount is evaluated as defective with regard to the area (SQ) to be inspected.

10. Method according to one of Claims 1 to 3 and Claim 8,
**characterized in that**,
as the assessment criterion for the area (SQ) to be inspected, an average value is formed from all the values of the reflection factor (R) that are determined along one or all measurement lines (LN) of this area (SQ) and of the area (SQ-1) that was inspected before this area (SQ), and a deviation of the average values of the respective values of the reflection factor (R) from one another by more than a prescribed amount is evaluated as defective with regard to the area (SQ) to be inspected.

11. Method according to one of Claims 1 to 3 and Claim 8,
**characterized in that**,
as the assessment criterion for the area (SQ) to be inspected, an average value is formed from the periodically occurring maximum values or minimum values of the reflection factor (R) along one or all the measurement lines (LN) of this area (SQ) and of the area (SQ-1) that was inspected before this area (SQ), and a deviation of the average values, formed from the respective periodically occurring maximum values or minimum values, from one another by more than a prescribed amount is evaluated as defective with regard to the area (SQ) to be inspected.

12. Method according to one of Claims 1 to 3 and Claim 8,
**characterized in that**
the periodically occurring minimum values of the reflection factor (R) of the area (SQ) to be inspected and of the area (SQ-1) that was inspected before this area (SQ) are used as the assessment criterion for this area (SQ), and a deviation of the respective minimum values from one another by more than a prescribed amount is evaluated as defective with regard to the area (SQ) to be inspected.

13. Method according to one of Claims 1 to 12,
**characterized in that** the imaginary measurement line (LN) is drawn parallel to the longer edge of the area (SQ) to be inspected.

14. Method according to one of Claims 1 to 12,
**characterized in that** the imaginary measurement line (LN) is drawn parallel to the shorter edge of the area (SQ) to be inspected.

15. Method according to one of the preceding claims,
**characterized in that** the area (SQ) to be inspected is inspected using more than one measurement line (LN).

## Revendications

1. Procédé de contrôle de plaquettes semi-conductrices (WF) qui servent à la fabrication de mémoires à semi-conducteurs intégrées dans laquelle les plaquettes semi-conductrices (WF) présentent une couche de laque (L), en dessous de laquelle se trouve déjà au moins une couche avec des structures (St) présentant les caractéristiques suivantes :
- les structures (St) sont rectangulaires, orientées parallèlement et disposées de façon périodique dans une matrice à deux dimensions sur les plaquettes semi-conductrices (WF),
- les structures (St) sont en grande partie régulières et correspondent dans ces parties aux surfaces à contrôler (SQ),
- les surfaces (SQ) présentent des degrés de réflexion élevés (R), la partie irrégulière des structures (St) et les cadres à rayure disposés entre elles présentent des valeurs de degré de réflexion (R) nettement plus basses ;
- le contrôle est effectué automatiquement par les étapes de procédé suivantes :
1) des zones (U), devant être soustraites au contrôle, et des surfaces (SQ), devant être contrôlées sont déterminées au moins dans la première plaquette semi-conductrice (WF) à contrôler selon les étapes suivantes :
1a) la plaquette semi-conductrice (WF) est éclairée à angle plat par rapport à la surface de la plaquette semi-conductrice (WF) de sorte que la couche de laque appliquée (L) réfléchit la lumière (Lt),
1b) au moyen d'une caméra (CAM) qui est disposée perpendiculairement au-dessus de la plaquette semi-conductrice (WF), et d'un dispositif d'évaluation (PC) qui y est raccordé, le degré de réflexion (R) de la lumière réfléchie (Lt) est déterminé et enregistré temporairement de la manière suivante :
1b1) concernant le degré de réflexion (R) une valeur minimale (Rmin) et une valeur maximale (Rmax) sont prédéfinies,
1b2) le long de deux lignes imaginaires (LNx, LNy), tracées l'une après l'autre, qui sont perpendiculaires l'une à l'autre et dont la ligne tracée d'abord (LNx) est orientée à l'avant des structures (St), le degré de réflexion (R) de la lumière réfléchie (Lt) sur les points choisis (Px, Py) des lignes imaginaires (LNx, LNy) est déterminé et enregistré temporairement,
1b3) s'il résulte dans au moins l'une des lignes imaginaires (LNx; LNy) une majorité de valeurs de degré de réflexion (R) qui sont inférieures à la valeur minimale prédéfinie (Rmin), l'étape 1b2) est alors répétée pour une autre ligne imaginaire (LNx1; LNy1), qui passe à distance parallèlement à la ligne imaginaire (LNx; LNy), laquelle présente une majorité de valeurs de degré de réflexion situées au-dessous de la valeur minimale (Rmin),
1b4) si l'étape 1b3) concernant l'autre ligne imaginaire (LNx1: LNy1) mène majoritairement à des valeurs de degré de réflexion (R) qui se situent au-dessous de la valeur minimale (Rmin), l'étape 1b3) est alors répétée aussi souvent à l'aide, à chaque fois, d'autres lignes imaginaires encore (LNx2, ...; LNy2, ...), qui se trouvent à distance par rapport, à chaque fois, aux lignes imaginaires (LNx2, ... ; LNy2, ...), jusqu'à ce qu'une ligne imaginaire (LNx2, ... ; LNy2, ...), dont les valeurs de degré de réflexion (R) remplissent majoritairement le critère de la valeur minimale (Rmin), soit trouvée,
1c) si les étapes 1b1) à 1b4) ne mènent pas à deux lignes imaginaires (LNx, ... ; LNy, ...), remplissant le critère de la valeur minimale (Rmin), le contrôle est alors interrompu, sinon, pour chacune des deux lignes imaginaires (LNx, LNy) sont déterminées, à partir de leurs points de positionnement (x ; y), des valeurs correspondant au degré de réflexion (R) ainsi qu'à l'information selon laquelle la plaquette semi-conductrice (WF) présente des structures (SQ) régulières, rectangulaires, disposées dans une matrice à deux dimensions avec une valeur élevée de degré de réflexion (R), les coordonnées (X, Y) se trouvant au-dessus d'une valeur maximale prédéfinie (Rmax), mais sont cependant dans le voisinage par rapport aux valeurs de positionnement (x ; y) dont le degré de réflexion (R) se situe au-dessous de la valeur maximale (Rmax),
1d) la quantité des coordonnées ainsi trouvées (X, Y) est en outre utilisée, dans un autre procédé pour soustraire au contrôle des zones (U) de la plaquette semi-conductrice (WF) à contrôler, qui présentent des degrés de réflexion (R) dont les valeurs se situent au-dessous de la valeur maximale (Rmax), de sorte qu'il résulte pour la plaquette conductrice (WF) à contrôler une pluralité de surfaces à contrôler (SQ), dans lesquelles lés coordonnées de leurs points d'angle respectifs (A, B, C, D) sont équivalentes aux coordonnées respectives déterminées (X, Y),
2) le contrôle de chaque surface (SQ) a encore lieu sous l'éclairage avec les étapes de procédé suivantes :
2a) au moins une ligne de mesure imaginaire (LN) est posée à travers la surface (SQ) à contrôler,
2b) le long de cette ligne de mesure (LN), sur des points de mesure prédéfinis (1, 2, 3, ...), la valeur respective du degré de réflexion (R) de la lumière réfléchie (Lt) est déterminée et enregistrée temporairement à l'aide de la caméra (CAM) et du dispositif d'évaluation (PC),
2c) pour reconnaître une seule erreur ou plusieurs erreurs, plusieurs des valeurs de degré de réflexion (R) mesurées et enregistrées temporairement le long de la ligne de mesure (LN) sont extraites, à partir de ces valeurs, des valeurs maximales ou minimales apparaissant sont déterminées ou des valeurs moyennes sont calculées, au moyen de ces valeurs et à l'aide d'un critère de jugement prédéfini, on obtient des informations permettant de savoir si la surface contrôlée (SQ) est correcte ou défectueuse,
2d) les surfaces (SQ) trouvées défectueuses sont détectées ;
3) pour le contrôle complémentaire suivant de chaque surface (SQ) selon les étapes 2a) à 2d)
- la plaquette semi-conductrice (WF) est éclairée à angle aigu par rapport à la surface de la plaquette semi-conductrice (WF),
- la caméra (CAM) est disposée à un angle (α) plus grand que 0° et plus petit que 90° par rapport à la surface de la plaquette semi-conductrice (WF)
- les distorsions résultant de cette disposition de la caméra concernant les coordonnées (X1, Y1) des surfaces (SQ) sont calculées à partir des coordonnées (X, Y), déterminées à l'origine, des surfaces (SQ) et de l'angle choisi (α) de la caméra (CAM), et
- à partir de ces coordonnées calculées (X1, Y1), les étapes de procédé sont exécutées selon les caractéristiques 2 à 2d).

2. Procédé selon la revendication 1, **caractérisé en ce que** lors de l'utilisation d'une charge de plaquettes semi-conductrices (HL) pour la deuxième plaquette semi-conductrice et les autres plaquettes semi-conductrices (WF) de la même charge de plaquettes semi-conductrices (WF) au lieu de détecter les coordonnées (X, Y) des points d'angle (A, B, C, D) de leurs surfaces (SQ) selon les étapes suivant les caractéristiques 1) à 1d) de la revendication 1, les coordonnées (X, Y) correspondantes déterminées pour la première plaquette (WF) de la charge sont prises pour base pour le contrôle des surfaces (SQ) de la plaquette semi-conductrice actuelle (WF).

3. Procédé selon l'une des revendications 1 ou 2, **caractérisé en ce que** sont uniquement contrôlées à l'aide de la caméra (CAM) disposée en angle (α) les surfaces (SQ) qui ont été reconnues comme étant correctes lors du contrôle à l'aide de la caméra (CAM) placée perpendiculairement.

4. Procédé selon l'une des revendications 1 à 3, **caractérisé en ce que** comme critère de jugement pour la surface (SQ) à contrôler, sont utilisées les valeurs maximales, apparaissant périodiquement, du degré de réflexion (R) et une divergence entre ces valeurs maximales de plus d'une valeur différentielle prédéfinie est estimée défectueuse pour la surface (SQ) à contrôler.

5. Procédé selon l'une des revendications 1 à 3, **caractérisé en ce que** comma critère de jugement pour la surface (SQ) à contrôler, une valeur moyenne est établie à partir de toutes les valeurs déterminées de degré de réflexion (R) le long d'une ou de toutes les lignes de mesures (LN) d'une surface (SQ), et une divergence de cette valeur moyenne d'une valeur prédéfinie de plus d'une mesure prédéfinie est estimée défectueuse pour la surface (SQ) à contrôler.

6. Procédé selon l'une des revendications 1 à 3, **caractérisé en ce que** comma critère de jugement pour la surface (SQ) à contrôler, une valeur moyenne est établie à partir des valeurs maximales, qui apparaissent périodiquement, du degré de réflexion (R) le long d'une ou de toutes les lignes de mesure (LN) d'une surface (SQ), et une divergence de cette valeur moyenne d'une valeur prédéfinie de plus d'une mesure prédéfinie est estimée défectueuse pour la surface (SQ) à contrôler.

7. Procédé selon l'une des revendications 1 à 3, **caractérisé en ce que** comma critère de jugement pour la surface (SQ) à contrôler, les valeurs minimales, qui apparaissent périodiquement, du degré de réflexion (R) sont utilisées, et une divergence entre ces valeurs minimales de plus d'une valeur différentielle prédéfinie est estimée défectueuse pour la surface (SQ) à contrôler.

8. Procédé selon l'une des revendications 1 à 3, **caractérisé en ce que** comma critère de jugement pour la surface (SQ) à contrôler au moins une partie des valeurs déterminées de degré de réflexion (R) est comparée à une partie correspondante des valeurs déterminées respectives de la surface (SQ-1) déjà contrôlée avant la surface (SQ) à contrôler actuellement, et comme critère de jugement, une divergence d'une mesure différentielle prédéfinie des valeurs ainsi comparées ensemble est utilisée.

9. Procédé selon l'une des revendications 1 à 3 et selon la revendication 8, **caractérisé en ce que** comme critère de jugement pour la surface à contrôler (SQ) les valeurs maximales, qui apparaissent périodiquement, de degré de réflexion (R) de cette surface (SQ) et de la surface (SQ-1) contrôlée avant cette surface (SQ) sont utilisées, et une divergence des valeurs maximales respectives entre elles de plus d'une mesure prédéfinie est estimée défectueuse pour la surface à contrôler (SQ).

10. Procédé selon l'une des revendications 1 à 3 et selon la revendication 8, **caractérisé en ce que** comme critère de jugement pour la surface (SQ) à contrôler une valeur moyenne est établie à partir de toutes les valeurs déterminées de degré de réflexion (R) le long d'une ou de toutes les lignes de mesure (LN) de cette surface (SQ) et de la surface (SQ-1) contrôlée avant cette surface (SQ), et une divergence entre les valeurs moyennes des valeurs respectives du degré de réflexion (R) de plus d'une mesure prédéfinie est estimée défectueuse pour la surface (SQ) à contrôler.

11. Procédé selon l'une des revendications 1 à 3 et selon la revendication 8, **caractérisé en ce que** comma critère de jugement pour la surface (SQ) à contrôler, une valeur moyenne est établie à partir des valeurs maximales ou des valeurs minimales de degré de réflexion (R), qui apparaissent périodiquement, le long d'une ou de toutes les lignes de mesure (LN) de cette surface (SQ) et de la surface (SQ-1) contrôlée avant cette surface (SQ), et une divergence de plus d'une mesure prédéfinie entre les valeurs moyennes établies à partir des valeurs maximales ou des valeurs minimales respectives, qui apparaissent périodiquement, est estimée défectueuse pour la surface (SQ) à contrôler.

12. Procédé selon l'une des revendications 1 à 3 et selon la revendication 8, **caractérisé en ce que** comme critère de jugement pour la surface (SQ) à contrôler, les valeurs minimales de degré de réflexion (R), qui apparaissent périodiquement, de cette surface (SQ) et de la surface (SQ-1) contrôlée avant cette surface (SQ), sont utilisées, et une divergence des valeurs minimales respectives l'une de l'autre de plus d'une valeur prédéfinie est estimée défectueuse pour la surface (SQ) à contrôler.

13. Procédé selon l'une des revendications 1 à 12, **caractérisé en ce que** la ligne de mesure imaginaire (LN) est posée parallèlement à l'arête la plus longue de la surface (SQ) à contrôler.

14. Procédé selon l'une des revendications 1 à 12, **caractérisé en ce que** la ligne de mesure imaginaire (LN) est posée parallèlement à l'arête la plus courte de la surface (SQ) à contrôler.

15. Procédé selon l'une des revendications précédentes, **caractérisé en ce que** la surface (SQ) à contrôler est contrôlée à l'aide de plus d'une ligne de mesure (LN).
mesure (LN).
